# EUROPEAN PATENT APPLICATION

(11) **EP 4 344 933 A1**
(43) Date of publication of application: **03.04.2024**
(21) Application number: 23306578.8
(22) Date of filing: 22.09.2023
(51) Int. Cl.: B60L 53/10, B60L 53/30, B60L 53/60, H05K 7/20

(54) **A CHARGING DEVICE AND A METHOD FOR PREVENTING CONDENSATION OF THE CHARGING DEVICE**

(30) Priority: 28.09.2022 CN 202211193173; 18.09.2023 CN 202311205920
(71) Applicant: Schneider Electric Industries SAS, 92500 Rueil-Malmaison (FR)
(72) Inventor: DE CESARIS, Stefano, 92500 Rueil-Malmaison (FR); SUN, Wei, Shanghai 201203 (CN)
(74) Representative: Manitz Finsterwald Patent- und Rechtsanwaltspartnerschaft mbB

(57) **Abstract**

A charging device, including a housing and a power module, a temperature sensor, a humidity sensor and a controller which are accommodated in the housing; the temperature sensor and the humidity sensor are respectively configured to collect a real-time temperature and a real-time relative humidity in an interior of the housing and provide the real-time temperature and real-time relative humidity as collected to the controller; the controller compares the real-time temperature as received with a threshold temperature and the controller compares the real-time relative humidity as received with a threshold humidity; upon one of following conditions being met, the controller sets the power module to a heating dew-removal mode, the conditions includes: I. the real-time temperature is less than or equal to the threshold temperature and greater than 0 degree; II. the real-time relative humidity is greater than or equal to the threshold humidity; in the heating dew-removal mode, the charging device is electrified to start the power module, which generates heat, but does not output current. The present disclosure also relates to a method for preventing dew condensation of a charging device.

## Description

### TECHNICAL FIELD

The present disclosure relates to a charging device, which is configured to convert alternating current into direct current, so as to charge the battery of an electric vehicle. The present disclosure also relates to a method for preventing dew condensation from occuring inside the charging device.

### BACKGROUND

If a charging device for an electric vehicle (such as a charging pile) is used in cold, humid and other environments, the phenomenon of dew condensation will easily occur inside the charging device. Dew condensation can easily cause instantaneous damage to the circuit board/power module in the charging device and rust the interior of the charging device. In order to solve this problem, the practice in the existing art is to add an additional heater to the charging device. However, this solution increases the structural complexity inside the charging device, increases the overall cost of the charging device and has the defect that the heater may interfere with the circuit board/power module. In addition, for the charging device already on site, if there is condensation problem, there is still a problem that there is not enough extra space inside the charging device to install an additional heater.

### SUMMARY

In order to solve one or more defects in the existing art, according to a first aspect of the present disclosure, a charging device is provided, which comprises a housing, and at least one power module accommodated in an interior of the housing, and can convert alternating current input into direct current output.

The charging device further includes a temperature sensor, a humidity sensor and a controller accommodated in an interior of the housing.

The temperature sensor is configured to collect a real-time temperature in the interior of the housing and provide the real-time temperature as collected to the controller.

The humidity sensor is configured to collect a real-time relative humidity in the interior of the housing and provide the real-time relative humidity as collected to the controller.

The controller compares the real-time temperature as received with a threshold temperature and the controller compares the real-time relative humidity as received with a threshold humidity.

Upon one of following conditions being met, the controller sets the power module to a heating dew-removal mode, the conditions comprise:
I. the real-time temperature is less than or equal to the threshold temperature and greater than 0 degree; and
II. the real-time relative humidity is greater than or equal to the threshold humidity;

Wherein, in the heating dew-removal mode, the charging device is electrified to start the power module, and the power module generates heat, but the power module does not output current.

The heat generated by the power module can improve the temperature inside the charging device and reduce the humidity inside the charging device.

According to the abovementioned aspect of the present disclosure, if the real-time temperature is greater than the threshold temperature and the real-time relative humidity is less than the threshold humidity, the controller sets the power module from the heating dew-removal mode to a standby mode.

In the standby mode, the charging device is electrified, but the power module is not started, the power module does not generate heat, and the power module does not output current.

According to the abovementioned aspect of the present disclosure, upon the charging device receiving a charging request, the controller sets the power module to a charging mode.

In the charging mode, the charging device is electrified to start the power module, and the power module generates heat and outputs current.

The heat generated by the power module can improve the temperature inside the charging device and reduce the humidity inside the charging device.

After the charging is finished, the controller sets the power module to a standby mode.

According to the abovementioned aspect of the present disclosure, in the heating dew-removal mode, the charging device is electrified to start a part of the power module.

According to the abovementioned aspect of the present disclosure, in the heating dew-removal mode, the charging device is electrified to start a part of the power module, and the part of the power module can deliver current to another part of the power module. That is, the power module is a bidirectional power module, and a part of the power module can be set as output, and the rest part of the power module can reversely output to an alternating current power grid. This can generate enough heat to heat the interior of the charging device.

According to the abovementioned aspect of the present disclosure, in the heating dew-removal mode, the charging device is electrified to start the power module, so that a part of the power module generates an inductive current and another part of the power module generates a capacitive current.

Inductive current and capacitive current can cancel each other in the circuit of the charging device, and the power module can generate heat, so more heat can be generated inside the power module.

According to the abovementioned aspect of the present disclosure, in the heating dew-removal mode, the charging device is electrified to start the power module, so that a part of the power module generates a first harmonic current with a first phase and another part of the power module generates a second harmonic current with a second phase, and the first phase and the second phase differ by 180 degrees.

This can make the current in the circuit of the charging device almost equal to zero, and at the same time, the power module can generate heat, so more heat can be generated inside the power module.

This can make the current in the circuit of the charging device almost equal to zero, and at the same time, the power module can generate heat, so more heat can be generated inside the power module.

According to the abovementioned aspect of the present disclosure, the controller is configured to communicate with a remote server in a two-way communication manner through a wireless connection or a wired connection and provides the real-time temperature as received and real-time relative humidity as received to the remote server.

The remote server determines the threshold temperature based on the real-time temperature as received and real-time relative humidity as received and according to a condensation chart stored on the remote server.

The remote server sets the threshold humidity to be lower than the real-time relative humidity as received.

The remote server transmits the threshold temperature set by the remote server to the controller at a certain time interval.

The remote server transmits the threshold humidity set by the remote server to the controller at a certain time interval.

A second aspect according to the present disclosure provides a method for preventing dew condensation of a charging device, the charging device is able to convert alternating current input into direct current output.

Providing at least one power module, a temperature sensor, a humidity sensor and a controller in an interior of a housing of the charging device.

Setting the temperature sensor to collect a real-time temperature in the interior of the housing and provide the real-time temperature as collected to the controller.

Setting the humidity sensor to collect a real-time relative humidity in the interior of the housing and provide the real-time relative humidity as collected to the controller.

The controller compares the real-time temperature as received with a threshold temperature and the controller compares the real-time relative humidity as received with a threshold humidity.

Upon one of following conditions being met, the controller sets the power module to a heating dew-removal mode, the conditions comprise:
I. the real-time temperature is less than or equal to the threshold temperature and greater than 0 degree.
II. the real-time relative humidity is greater than or equal to the threshold humidity.

Wherein, in the heating dew-removal mode, the charging device is electrified to start the power module, and the power module generates heat, but the power module does not output current.

The heat generated by the power module can improve the temperature inside the charging device and reduce the humidity inside the charging device.

According to the second aspect of the present disclosure, if the real-time temperature is greater than the threshold temperature and the real-time relative humidity is less than the threshold humidity, the controller sets the power module from the heating dew-removal mode to a standby mode.

In the standby mode, the charging device is electrified, but the power module is not started, the power module does not generate heat, and the power module does not output current.

According to the second aspect of the present disclosure, upon the charging device receiving a charging request, the controller sets the power module to a charging mode.

In the charging mode, the charging device is electrified to start the power module, and the power module generates heat and outputs current.

The heat generated by the power module can improve the temperature inside the charging device and reduce the humidity inside the charging device.

After the charging is finished, the controller sets the power module to a standby mode.

According to the second aspect of the present disclosure, in the heating dew-removal mode, the charging device is electrified to start a part of the power module.

According to the second aspect of the present disclosure, in the heating dew-removal mode, the charging device is electrified to start a part of the power module, and the part of the power module can deliver current to another part of the power module.

According to the second aspect of the present disclosure, in the heating dew-removal mode, the charging device is electrified to start the power module, so that a part of the power module generates an inductive current and another part of the power module generates a capacitive current.

Inductive current and capacitive current can cancel each other in the circuit of the charging device, and the power module can generate heat, so more heat can be generated inside the power module.

According to the second aspect of the present disclosure, in the heating dew-removal mode, the charging device is electrified to start the power module, so that a part of the power module generates a first harmonic current with a first phase and another part of the power module generates a second harmonic current with a second phase, and the first phase and the second phase differ by 180 degrees.

This can make the current in the circuit of the charging device almost equal to zero, and at the same time, the power module can generate heat, so more heat can be generated inside the power module.

According to the second aspect of the present disclosure, the controller is configured to communicate with a remote server in a two-way communication manner through a wireless connection or a wired connection and provides the real-time temperature as received and real-time relative humidity as received to the remote server.

The remote server determines the threshold temperature based on the real-time temperature as received and real-time relative humidity as received and according to a condensation chart stored on the remote server.

The remote server sets the threshold humidity to be lower than the real-time relative humidity as received.

The remote server transmits the threshold temperature set by the remote server to the controller at a certain time interval.

The remote server transmits the threshold humidity set by the remote server to the controller at a certain time interval.

The charging device and the method for preventing dew condensation of the charging device according to the present disclosure prevent dew condensation inside the charging device. Instantaneous damage of the circuit board/power module in the charging device which may be caused by the dew condensation can be avoided. The charging device and the method for preventing the dew condensation of the charging device according to the present disclosure can reduce the rust inside the housing of the charging device during the service life of the charging device, thereby prolonging the service life of the charging device by reducing the corrosion rate.

Because no additional internal heater is used, only the power module and the control method of the power module are used (that is, the power module is used as an internal heater), the charging device and the method for preventing the dew condensation of the charging device according to the present disclosure reduce the structural complexity inside the charging device, reduce the overall cost of the charging device, and avoid the defect that the heater may interfere with the circuit board/power module. In addition, for the equipment that is already on the site, if there is a dew condensation problem, but there is no heater, the problem can be solved by upgrading the firmware without adding an additional component, and there is no need to face the problem that there is not enough extra space inside the charging device to install an additional heater.

So far, in order to make the detailed description of the present disclosure herein be better understood and make the contribution of the present disclosure to the existing art be better recognized, the present disclosure has outlined the contents of the present disclosure quite broadly. Of course, embodiments of the present disclosure will be described below and will form the subject of the appended claims.

Likewise, those skilled in the art will recognize that the concept on which the present disclosure is based can be easily used as a basis for designing other structures, methods and systems for carrying out the several purposes of the present disclosure. Therefore, it is important that the appended claims should be regarded as including such equivalent structures as long as they do not exceed the spirit and scope of the present disclosure.

### BRIEF DESCRIPTION OF DRAWINGS

Those skilled in the art will have a better understanding of the present disclosure through the following drawings, and the advantages of the present disclosure can be more clearly reflected. The drawings described here are only for illustrative purposes of selected embodiments, not all possible implementations, and are not intended to limit the scope of the present disclosure.
Fig. 1 is a schematic diagram of at least one power module, a temperature sensor, a humidity sensor and a controller which are accommodated in a housing of a charging device according to the present disclosure;
Fig. 2 shows three operating modes of a charging device according to the present disclosure;
Fig. 3 shows that a power module of a charging device according to the present disclosure is a bidirectional power module, in which a part of the power module is set to output, and the rest part of the power module can reversely output to an alternating current power grid;
Fig. 4 shows a condensation chart stored on a remote server.

### DETAILED DESCRIPTION

In the following, specific embodiments according to the present disclosure will be described in detail with reference to the accompanying drawings.

The present disclosure is about how to prevent the dew condensation phenomenon occurring in an AC/DC charging device. The solution is to use the heat generated by the energy loss of the power module to heat the interior of the charging device. The threshold humidity and the threshold temperature will be set in a remote server to start the power module.

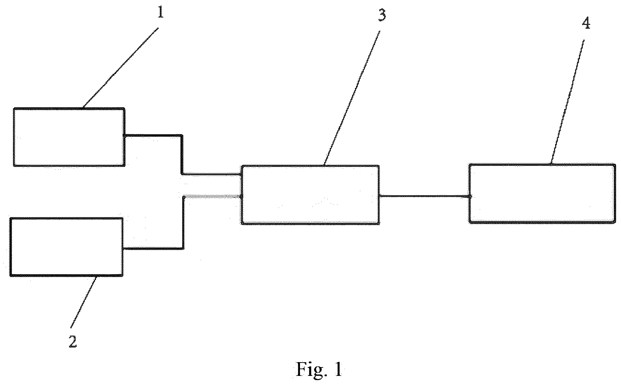

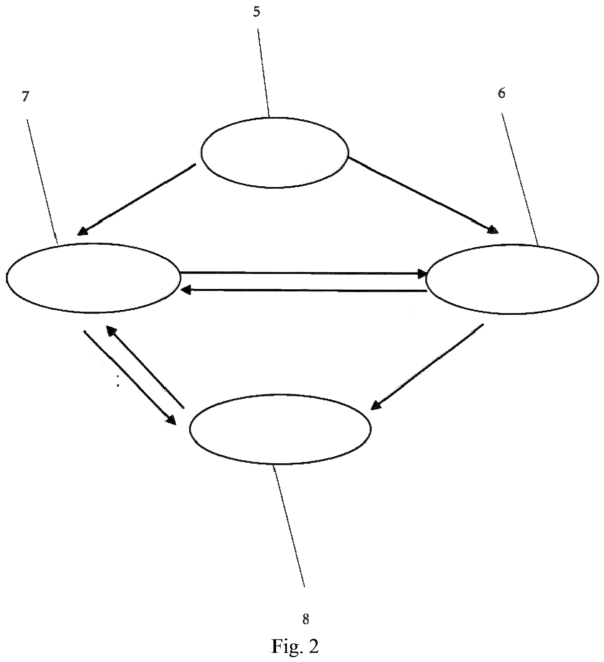

The solution according to the present disclosure is mainly implemented by a hardware architecture (as illustrated by Fig. 1) and a firmware (as illustrated by Fig. 2). As illustrated by Fig. 1, from the perspective of the hardware architecture, the charging device according to the present disclosure includes a temperature sensor 1, a humidity sensor 2, a controller 3 and at least one power module 4. The temperature sensor 1, the humidity sensor 2, the controller 3 and at least one power module 4 are all accommodated in a housing (not shown) of the charging device.

The power module 4 includes, but is not limited to, a power factor correction module, a transformer, an insulate-gate bipolar transistor, etc., the insulate-gate bipolar transistor is a composite full-control voltage-driven power semiconductor device composed of BJT (bipolar transistor) and MOS (insulate-gate field effect transistor).

The charging device can convert alternating current input into direct current and output the direct current to a charging gun, for example, for charging an electric vehicle.

Upon the charging device being electrified to start the power module 4, the power factor correction module, the transformer, the insulate-gate bipolar transistor, etc. will generate heat due to the passage of current.

The temperature sensor 1 is configured to collect a real-time temperature in the interior of the housing and provide the real-time temperature as collected to the controller 3.

The humidity sensor 2 is configured to collect a real-time relative humidity in the interior of the housing and provide the real-time relative humidity as collected to the controller 3.

The controller 3 compares the real-time temperature as received with a threshold temperature and compares the real-time relative humidity as received with a threshold humidity based on a firmware running in the controller 3.

Upon one of following conditions being met, the controller 3 sets the power module 4 to a heating dew-removal mode 6, the conditions include:
I. the real-time temperature is less than or equal to the threshold temperature and greater than 0 degree; and
II. the real-time relative humidity is greater than or equal to the threshold humidity.

As illustrated by Fig. 2, in the heating dew-removal mode, the charging device is electrified to start the power module 4, which generates heat (that is, the power factor correction module, the transformer and the insulate-gate bipolar transistor will generate heat), but the power module 4 will not output current.

The heat generated by the power module 4 can increase the temperature inside the charging device and reduce the humidity inside the charging device.

According to the above embodiment of the present disclosure, the controller 3 is configured to communicate with a remote server 5 in a two-way communication manner through a wireless connection or a wired connection and provides the real-time temperature as received and real-time relative humidity as received to the remote server.

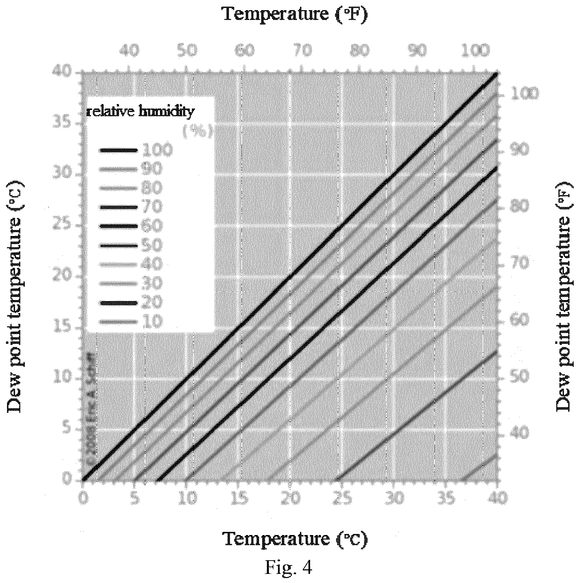

A condensation chart based on historical temperature and historical relative humidity (as illustrated by Fig. 4) is stored on the remote server, in which the abscissa represents temperature (lower abscissa represents Celsius and upper abscissa represents Fahrenheit), different diagonal lines represent corresponding relative humidity, and the ordinate represents dew point temperature (left ordinate represents Celsius and right ordinate represents Fahrenheit). In Fig. 4, if the temperature is =10 °C and the relative humidity is 70%, the dew point temperature is 5 °C.

The remote server determines the threshold temperature based on the real-time temperature as received and real-time relative humidity as received and according to the condensation chart. For example, if the real-time temperature and real-time relative humidity received by the remote server are 10 °C and 70% respectively, the remote server sets the dew point temperature = 5 °C as the threshold temperature based on the condensation chart, that is, the threshold temperature = 5 °C. In addition, the remote server sets the threshold humidity to be lower than the real-time relative humidity as received, such as but not limited to 1% to 2%, so the threshold humidity ranges from 68% to 69%.

The remote server transmits the threshold temperature set by the remote server to the controller 3 at a certain time interval, for example, every 1 to 4 hours.

The remote server transmits the threshold humidity set by the remote server to the controller 3 at a certain time interval, for example, every 1 to 4 hours.

According to the above embodiment of the present disclosure, if the real-time temperature is greater than the threshold temperature and the real-time relative humidity is less than the threshold humidity, the controller 3 sets the power module from the heating dew-removal mode 6 to a standby mode 7.

As illustrated by Fig. 2, in the standby mode, the charging device is electrified, but the power module 4 is not started, and the power module 4 does not generate heat (that is, the power factor correction module, the transformer and the insulate-gate bipolar transistor do not generate heat because there is no current flowing through them), and the power module 4 does not output current to the outside.

According to the above embodiment of the present disclosure, upon the charging device receiving a charging request, the controller 3 sets the power module 4 to a charging mode 8.

In the charging mode, the charging device is electrified to start the power module 4, which generates heat (that is, the power factor correction module, the transformer and the insulate-gate bipolar transistor will generate heat), and the power module 4 outputs current.

The heat generated by the power module 4 can increase the temperature inside the charging device and reduce the humidity inside the charging device.

After the charging is completed, the controller 4 sets the power module 4 to the standby mode 7.

According to the above embodiment of the present disclosure, in the heating dew-removal mode 6, the charging device is electrified to start a part of the power module 4, while the other part of the power module 4 is not started.

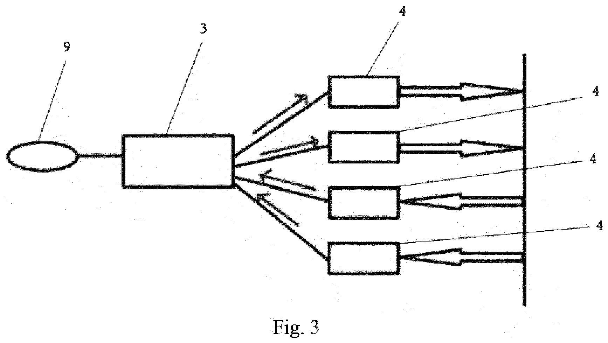

According to the above embodiment of the present disclosure, as illustrated by Fig. 3, in the heating dew-removal mode 6, the charging device is electrified to start a part of the power module 4, and the part of the power module 4 can deliver current to another part of the power module 4. That is, the power module 4 is a bidirectional power module, and a part of the power module 4 can be set as output, and the rest part of the power module 4 can reversely output to an alternating current power grid 9. This can generate enough heat to heat the interior of the charging device.

According to the above embodiment of the present disclosure, in the heating dew-removal mode, the charging device is electrified to start the power module 4, so that a part of the power module 4 generates an inductive current and another part of the power module 4 generates a capacitive current.

Inductive current and capacitive current can cancel each other in the circuit of the charging device, and the power module 4 can generate heat, so more heat can be generated inside the power module 4.

According to the above embodiment of the present disclosure, in the heating dew-removal mode, the charging device is electrified to start the power module 4, so that a part of the power module 4 generates a first harmonic current with a first phase (degree) and another part of the power module 4 generates a second harmonic current with a second phase (degree), and the first phase and the second phase differ by 180 degrees.

This can make the current in the circuit of the charging device almost equal to zero, and at the same time, the power module can generate heat, so more heat can be generated inside the power module 4.

According to another embodiment of the present disclosure, a method for preventing dew condensation of a charging device is provided. As illustrated by Figs. 1 to 3, the charging device can convert alternating current input into direct current output.

At least one power module 4, a temperature sensor 1, a humidity sensor 2 and a controller 3 are arranged in the interior of a housing (not shown) of the charging device.

The temperature sensor 1 is configured to collect a real-time temperature in the interior of the housing and provide the real-time temperature as collected to the controller 3.

The humidity sensor 2 is configured to collect a real-time relative humidity in the interior of the housing and provide the real-time relative humidity as collected to the controller 3.

The controller 3 compares the real-time temperature as received with a threshold temperature and the controller compares the real-time relative humidity as received with a threshold humidity.

Upon one of following conditions being met, the controller 3 sets the power module 4 to a heating dew-removal mode 6, the conditions include:
I. the real-time temperature is less than or equal to the threshold temperature and greater than 0 degree; and
II. the real-time relative humidity is greater than or equal to the threshold humidity.

In the heating dew-removal mode 6, the charging device is electrified to start the power module 4, which generates heat (that is, the power factor correction module, the transformer and the insulate-gate bipolar transistor will generate heat), but the power module 4 will not output current.

The heat generated by the power module 4 can increase the temperature inside the charging device and reduce the humidity inside the charging device.

According to another embodiment of the present disclosure, if the real-time temperature is greater than the threshold temperature and the real-time relative humidity is less than the threshold humidity, the controller 3 sets the power module from the heating dew-removal mode 6 to a standby mode 7.

In the standby mode 7, the charging device is electrified, but the power module 4 is not started, and the power module 4 does not generate heat (that is, the power factor correction module, the transformer and the insulate-gate bipolar transistor do not generate heat because there is no current flowing through), and the power module 4 does not output current to the outside.

According to another embodiment of the present disclosure, upon the charging device receiving a charging request, the controller 3 sets the power module 4 to a charging mode.

In the charging mode, the charging device is electrified to start the power module 4, which generates heat (that is, the power factor correction module, transformer and insulate-gate bipolar transistor will generate heat), and the power module 4 outputs current.

The heat generated by the power module 4 can increase the temperature inside the charging device and reduce the humidity inside the charging device.

After the charging is completed, the controller 3 sets the power module 4 to the standby mode.

According to another embodiment of the present disclosure, in the heating dew-removal mode 6, the charging device is electrified to start a part of the power module 4.

According to another embodiment of the present disclosure, in the heating dew-removal mode 6, the charging device is electrified to start a part of the power module 4, and the part of the power module 4 can deliver current to another part of the power module 4.

According to another embodiment of the present disclosure, in the heating dew-removal mode, the charging device is electrified to start the power module, so that a part of the power module 4 generates an inductive current and another part of the power module 4 generates a capacitive current.

Inductive current and capacitive current can cancel each other in the circuit of the charging device, and the power module 4 can generate heat, so more heat can be generated inside the power module 4.

According to another embodiment of the present disclosure, in the heating dew-removal mode, the charging device is electrified to start the power module 4, so that a part of the power module 4 generates a first harmonic current with a first phase (degree) and another part of the power module 4 generates a second harmonic current with a second phase (degree), and the first phase and the second phase differ by 180 degrees.

This can make the current in the circuit of the charging device almost equal to zero, and at the same time, the power module can generate heat, so more heat can be generated inside the power module 4.

According to the abovementioned another embodiment of the present disclosure, the controller 3 is configured to communicate with a remote server (not shown) in a two-way communication manner through a wireless connection or a wired connection and the controller 3 provides the real-time temperature as received and real-time relative humidity as received to the remote server.

A condensation chart based on historical temperature and historical relative humidity (as illustrated by Fig. 4) is stored on the remote server, in which the abscissa represents temperature (lower abscissa represents Celsius and upper abscissa represents Fahrenheit), different diagonal lines represent corresponding relative humidity, and the ordinate represents dew point temperature (left ordinate represents Celsius and right ordinate represents Fahrenheit). In Fig. 4, if the temperature is =10 °C and the relative humidity is 70%, the dew point temperature is 5 °C.

The remote server determines the threshold temperature based on the real-time temperature as received and real-time relative humidity as received and according to the condensation chart. For example, if the real-time temperature and real-time relative humidity received by the remote server are 10 °C and 70% respectively, the remote server sets the dew point temperature = 5 °C as the threshold temperature based on the condensation chart, that is, the threshold temperature = 5 °C. In addition, the remote server sets the threshold humidity to be lower than the real-time relative humidity as received, such as but not limited to 1% to 2%, so the threshold humidity ranges from 68% to 69%.

The remote server transmits the threshold temperature set by the remote server to the controller 3 at a certain time interval, for example, every 1 to 4 hours.

The remote server transmits the threshold humidity set by the remote server to the controller 3 at a certain time interval, for example, every 1 to 4 hours.

The charging device and the method for preventing dew condensation of the charging device according to the embodiment of the present disclosure prevent dew condensation inside the charging device. Instantaneous damage of the circuit board/power module in the charging device which may be caused by dew condensation is avoided. The charging device and the method for preventing the dew condensation of the charging device according to the embodiment of the present disclosure can reduce the rust inside the housing of the charging device during the service life of the charging device, thereby prolonging the service life of the charging device by reducing the corrosion rate.

Because no additional internal heater is used, only the power module and the control method of the power module are used (that is, the power module is used as an internal heater), the charging device and the method for preventing the dew condensation of the charging device according to the present disclosure reduce the structural complexity inside the charging device, reduce the overall cost of the charging device, and avoid the defect that the heater may interfere with the circuit board/power module. In addition, for the equipment that is already on the site, if there is a dew condensation problem, but there is no heater, the problem can be solved by upgrading the firmware without adding an additional component, and there is no need to face the problem that there is not enough extra space inside the charging device to install an additional heater.

The foregoing disclosure provides illustration and description, but is not intended to be exhaustive or to limit the embodiments to the precise forms disclosed. Modifications and variations are possible in light of the above disclosure, or may be acquired from practice of the embodiments.

Even if specific combinations of features are recited in the claims and/or disclosed in the specification, these combinations are not intended to limit the disclosure of various embodiments. In fact, many of these features can be combined in ways not specifically recited in the claims and/or not specifically disclosed in the specification. Although each dependent claim listed below may directly depend on only one claim, the disclosure of various embodiments includes each dependent claim in combination with every other claim in the claim set.

## Claims

1. A charging device, comprising a housing and at least one power module accommodated in the housing, wherein the charging device can convert alternating current input into direct current output, which is **characterized in that**,
the charging device further comprises a temperature sensor, a humidity sensor and a controller accommodated in an interior of the housing;
the temperature sensor is configured to collect a real-time temperature in the interior of the housing and provide the real-time temperature as collected to the controller;
the humidity sensor is configured to collect a real-time relative humidity in the interior of the housing and provide the real-time relative humidity as collected to the controller;
the controller compares the real-time temperature as received with a threshold temperature and the controller compares the real-time relative humidity as received with a threshold humidity; and
upon one of following conditions being met, the controller sets the power module to a heating dew-removal mode, the conditions comprise:
I. the real-time temperature is less than or equal to the threshold temperature and greater than 0 degree; and
II. the real-time relative humidity is greater than or equal to the threshold humidity;
wherein, in the heating dew-removal mode, the charging device is electrified to start the power module, and the power module generates heat, but the power module does not output current.

2. The charging device according to claim 1, wherein,
if the real-time temperature is greater than the threshold temperature and the real-time relative humidity is less than the threshold humidity, the controller sets the power module from the heating dew-removal mode to a standby mode;
in the standby mode, the charging device is electrified, but the power module is not started, the power module does not generate heat, and the power module does not output current.

3. The charging device according to claim 1 or 2, wherein,
upon the charging device receiving a charging request, the controller sets the power module to a charging mode;
in the charging mode, the charging device is electrified to start the power module, and the power module generates heat and outputs current;
after the charging is finished, the controller sets the power module to a standby mode.

4. The charging device according to any one of the preceding claims, wherein,
in the heating dew-removal mode, the charging device is electrified to start a part of the power module.

5. The charging device according to any one of the preceding claims, wherein,
in the heating dew-removal mode, the charging device is electrified to start a part of the power module, and the part of the power module can deliver current to another part of the power module.

6. The charging device according to any one of the preceding claims, wherein,
in the heating dew-removal mode, the charging device is electrified to start the power module, so that a part of the power module generates an inductive current and another part of the power module generates a capacitive current, or
in the heating dew-removal mode, the charging device is electrified to start the power module, so that a part of the power module generates a first harmonic current with a first phase and another part of the power module generates a second harmonic current with a second phase, and the first phase and the second phase differ by 180 degrees.

7. The charging device according to any one of the preceding claims, wherein,
the controller is configured to communicate with a remote server in a two-way communication manner through a wireless connection or a wired connection and provides the real-time temperature as received and real-time relative humidity as received to the remote server;
the remote server determines the threshold temperature based on the real-time temperature as received and real-time relative humidity as received and according to a condensation chart stored on the remote server;
the remote server sets the threshold humidity to be lower than the real-time relative humidity as received;
the remote server transmits the threshold temperature set by the remote server to the controller at a certain time interval; and
the remote server transmits the threshold humidity set by the remote server to the controller at a certain time interval.

8. A method for preventing dew condensation of a charging device, wherein the charging device is able to convert alternating current input into direct current output, which is **characterized in that**,
providing at least one power module, a temperature sensor, a humidity sensor and a controller in an interior of a housing of the charging device;
setting the temperature sensor to collect a real-time temperature in the interior of the housing and provide the real-time temperature as collected to the controller;
setting the humidity sensor to collect a real-time relative humidity in the interior of the housing and provide the real-time relative humidity as collected to the controller;
the controller compares the real-time temperature as received with a threshold temperature and the controller compares the real-time relative humidity as received with a threshold humidity;
upon one of following conditions being met, the controller sets the power module to a heating dew-removal mode, the conditions comprise:
I. the real-time temperature is less than or equal to the threshold temperature and greater than 0 degree; and
II. the real-time relative humidity is greater than or equal to the threshold humidity;
wherein, in the heating dew-removal mode, the charging device is electrified to start the power module, and the power module generates heat, but the power module does not output current.

9. The method according to claim 8, wherein,
if the real-time temperature is greater than the threshold temperature and the real-time relative humidity is less than the threshold humidity, the controller sets the power module from the heating dew-removal mode to a standby mode;
in the standby mode, the charging device is electrified, but the power module is not started, the power module does not generate heat, and the power module does not output current.

10. The method according to any one of claims 8-9, wherein,
upon the charging device receiving a charging request, the controller sets the power module to a charging mode;
in the charging mode, the charging device is electrified to start the power module, and the power module generates heat and outputs current;
after the charging is finished, the controller sets the power module to a standby mode.

11. The method according to any one of claims 8 - 10, wherein,
in the heating dew-removal mode, the charging device is electrified to start a part of the power module.

12. The method according to any one of claims 8 - 11, wherein,
in the heating dew-removal mode, the charging device is electrified to start a part of the power module, and the part of the power module can deliver current to another part of the power module.

13. The method according to any one of claims 8 - 12, wherein,
in the heating dew-removal mode, the charging device is electrified to start the power module, so that a part of the power module generates an inductive current and another part of the power module generates a capacitive current, or
in the heating dew-removal mode, the charging device is electrified to start the power module, so that a part of the power module generates a first harmonic current with a first phase and another part of the power module generates a second harmonic current with a second phase, and the first phase and the second phase differ by 180 degrees.

14. The method according to any one of claims 8 - 13, wherein,
the controller is configured to communicate with a remote server in a two-way communication manner through a wireless connection or a wired connection and provides the real-time temperature as received and real-time relative humidity as received to the remote server;
the remote server determines the threshold temperature based on the real-time temperature as received and real-time relative humidity as received and according to a condensation chart stored on the remote server;
the remote server sets the threshold humidity to be lower than the real-time relative humidity as received;
the remote server transmits the threshold temperature set by the remote server to the controller at a certain time interval; and
the remote server transmits the threshold humidity set by the remote server to the controller at a certain time interval.
